# EUROPÄISCHE PATENTSCHRIFT

(11) **EP 3 539 192 B1**
(45) Veröffentlichungstag und Bekanntmachung des Hinweises auf die Patenterteilung: **12.08.2020**
(21) Anmeldenummer: 17801400.7
(22) Anmeldetag: 09.11.2017
(51) Int. Cl.: H02H 7/26, B60R 16/03, H02H 3/24, H03K 17/284

(54) **LEISTUNGSVERTEILER UND BORDNETZ MIT ZUMINDEST EINEM LEISTUNGSVERTEILER**
POWER DISTRIBUTION MODULE AND VEHICLE CIRCUIT WITH AT LEAST ONE POWER DISTRIBUTION MODULE
MODULE DE DISTRIBUTION D'ÉNERGIE ET CIRCUIT DE VÉHICULE COMPRENANT AU MOINS UN MODULE DE DISTRIBUTION D'ÉNERGIE

(30) Priorität: 11.11.2016 DE 102016222173
(43) Veröffentlichungstag der Anmeldung: 18.09.2019
(73) Patentinhaber: LEONI Bordnetz-Systeme GmbH, 97318 Kitzingen (DE)
(72) Erfinder: DÖRNBACH, Sebastian, 97218 Gerbrunn (DE); GRABS, Peter, 97084 Würzburg (DE); ULJANOW, Ilja, 97084 Würzburg (DE)
(74) Vertreter: FDST Patentanwälte
(86) Internationale Anmeldenummer: PCT/EP2017/078818
(87) Internationale Veröffentlichungsnummer: WO 2018/087260

(56) Entgegenhaltungen:
- EP-A1- 0 711 014
- EP-A2- 0 836 966
- EP-A2- 1 493 630
- DE-A1-102004 055 057
- DE-A1-102012 207 624
- DE-A1-102015 101 235

## Beschreibung

Die Erfindung betrifft einen Leistungsverteiler, insbesondere für ein Bordnetz eines Kraftfahrzeuges, aufweisend zwei Leistungsausgänge und einen Zwischenabgriff. Sie betrifft außerdem ein Bordnetz mit zumindest einem derartigen Leistungsverteiler.

Bordnetze für den Kraftfahrzeugbereich sind prinzipiell bekannt und beispielsweise in der DE 10 2015 101 235 A1 beschrieben. Hierbei werden Bordnetze für eine hohe Funktionssicherheit zunehmend als sogenannte redundante Bordnetze ausgestaltet. Dabei weist ein entsprechendes redundantes Bordnetz zumindest zwei elektrische Energiequellen auf, die unabhängig voneinander in das redundante Bordnetz eingebundene elektrische Verbraucher versorgen können. Zudem sind die entsprechenden elektrischen Verbraucher typischerweise über zwei voneinander unabhängige Leitungswege mit den elektrischen Energiequellen verbunden, sodass nicht nur bei einem Ausfall einer der beiden elektrischen Energiequellen, sondern auch im Falle eines Ausfalls eines der Leitungswege, also bei einer Unterbrechung entlang eines der Leitungswege, die Versorgung des entsprechenden Verbrauchers über den jeweils anderen Leitungsweg sowie die daran angebundene elektrische Energiequelle aufrecht erhalten werden kann.

Die Bedeutung derartiger redundanter Bordnetze hat dabei zuletzt auch deswegen zugenommen, da Kraftfahrzeuge mit immer mehr Assistenzsystemen ausgestattet werden. Entsprechende Assistenzsysteme dienen hierbei nicht nur zur Erhöhung des Komforts sondern auch zur Erhöhung der Sicherheit, weswegen deren Funktion mit besonders hoher Zuverlässigkeit sichergestellt werden soll.

Dies geschieht unter anderem durch den Einsatz der zuvor genannten redundanten Bordnetze, bei denen üblicherweise mehrere Leistungsverteiler als Versorgungsknoten in einer Ringform oder in einer Strangform angeordnet sind. Dabei dient jeder Leistungsverteiler zur Versorgung einer Anzahl elektrischer Verbraucher und weist zwei Versorgungseingänge auf, über die elektrische Leistung von zwei unabhängigen elektrischen Energiequellen eingespeist werden kann.

Problematisch für derartige redundante Bordnetze sind jedoch Spannungsabfälle, die beispielsweise durch einen sogenannten Kurzschluss hervorgerufen werden, da sich derartige Spannungsabfälle typischerweise auch bis zu den Versorgungsknoten hin fortpflanzen, sodass die Versorgungsspannung auch an den Versorgungsknoten, also an den Leistungsverteilern, zusammenbricht. Sind nun beispielsweise Steuergeräte als elektrische Verbraucher an einen solchen Leistungsverteiler angebunden, so führt ein entsprechender Spannungsabfall bei diesen in der Regel dazu, dass diese in einen sogenannten Auto-Reset-Betriebszustand fallen oder zurückversetzt werden und infolgedessen über einen potenziell problematisch langen Zeitraum inaktiv sind. Ein Fahrerassistenzsystem, welches mit Hilfe eines entsprechenden Steuergeräts realisiert ist, fällt dann dementsprechend über einen gewissen Zeitraum hinweg aus. Dies ist insbesondere problematisch im Falle von Fahrerassistenzsystemen, die für eine teilautomatisierte oder vollautomatisierte Fahrzeugführung, also für das sogenannte autonome Fahren, ausgebildet sind.

Ausgehend hiervon liegt der Erfindung die Aufgabe zugrunde, ein vorteilhaft ausgebildetes Bordnetz und einen vorteilhaft ausgebildeten Leistungsverteiler anzugeben.

Diese Aufgabe wird erfindungsgemäß gelöst durch einen Leistungsverteiler (IPDN) mit den Merkmalen des Anspruchs 1 sowie durch ein Bordnetz mit den Merkmalen des Anspruchs 8. Bevorzugte Weiterbildungen sind in den rückbezogenen Ansprüchen enthalten. Die im Hinblick auf den Leistungsverteiler angeführten Vorteile und bevorzugten Ausgestaltungen sind sinngemäß auch auf das Bordnetz übertragbar und umgekehrt.

Dabei werden mit einem entsprechenden Leistungsverteiler (IPDN) und/oder mit einem entsprechenden Bordnetz zwei Ideenansätze verfolgt. Einer der Ideenansätze besteht hierbei darin, ein einfacher ausgestaltetes redundantes Bordnetz zu realisieren sowie einen einfacher ausgestalteten Leistungsverteiler.

Dazu wird der Umstand ausgenutzt, dass typischerweise nicht alle elektrischen Verbraucher sicherheitsrelevant sind und dementsprechend nicht alle elektrischen Verbraucher durch zwei unabhängige Versorgungsmöglichkeiten abgesichert werden sollen oder müssen. Infolgedessen lässt sich dann das Bordnetz und/oder lassen sich die im Bordnetz eingesetzten Leistungsverteiler einfacher gestalten. Eine solche vereinfachte Ausführung ist dabei insbesondere von Vorteil, wenn diese in einem Kraftfahrzeug eingesetzt wird, welches eine relativ geringe Anzahl sicherheitsrelevanter elektrischer Verbraucher aufweist und/oder welches lediglich für eine teilautomatisierte Fahrzeugführung ausgebildet ist und nicht für eine vollautomatisierte Fahrzeugführung. Ein hierfür ausgebildeter Leistungsverteiler (IPDN) weist dabei zumindest zwei schaltbare Leistungsausgänge, die jeweils auch als Versorgungsanschlüsse nutzbar sind, auf, wobei die schaltbaren Leistungsausgänge bevorzugt derart ausgestaltet sind, dass in einem Fehlerfall der jeweils am direktesten mit der Fehlerquelle verbundene Leistungsausgang und insbesondere lediglich der jeweils am direktesten mit der Fehlerquelle verbundene Leistungsausgang schnell abgeschaltet, abgetrennt oder gesperrt wird. Bevorzugt weist ein solcher Leistungsverteiler (IPDN) dann keine weiteren Leistungsausgänge auf.

Der zweite Ideenansatz ist darin zu sehen, dass die eingangs genannten einfachen Versorgungsknoten, beispielsweise die einfachen Versorgungsknoten einer Ringform oder Ringleitung (Powerring), ersetzt werden durch Leistungsverteiler (IPDNs) mit zumindest zwei schaltbaren Leistungsausgänge, wobei die schaltbaren Leistungsausgänge bevorzugt derart ausgestaltet sind, dass in einem Fehlerfall der jeweils am direktesten mit der Fehlerquelle verbundene Leistungsausgang und insbesondere lediglich der jeweils am direktesten mit der Fehlerquelle verbundene Leistungsausgang oder die jeweils am direktesten mit der Fehlerquelle verbundenen Leistungsausgänge und insbesondere lediglich die jeweils am direktesten mit der Fehlerquelle verbundenen Leistungsausgänge schnell abgeschaltet, abgetrennt oder gesperrt wird bzw. werden.

Die Abschaltung, Abtrennung oder Sperrung bewirkt dabei im Sinne dieser Anmeldung in beiden Fällen, dass über den entsprechenden gesperrten Leistungsausgang kein elektrischer Strom mehr aus dem Leistungsverteiler (IPDN) herausfließen kann, wohingegen es typischerweise weiterhin möglich ist, dass elektrischer Strom über den entsprechenden gesperrten Versorgungsanschluss in den Leistungsverteiler hineinfließt.

Erfindungsgemäß wird hierbei zur Abschaltung, Abtrennung oder Sperrung ein verzögernd schaltendes Abschaltelement eingesetzt, bei dem die Verzögerung weiter bevorzugt abnimmt, je stärker die Spannung abfällt und bei dem die Verzögerung insbesondere umgekehrt proportional zur Tiefe des Spannungsabfalls ist, so dass beispielsweise in einer Anordnung mehrerer Abschaltelemente dasjenige am schnellsten reagiert und schaltet, das sich am nächsten am Ursprung des Spannungsabfalls befindet.

Die Erkennung des Fehlerfalls erfolgt dabei beispielsweise durch eine dynamische Beurteilung eines auftretenden Spannungsabfalls oder Spannungszusammenbruchs, wobei weiter bevorzugt dem entsprechenden Leistungsverteiler oder den entsprechenden Leistungsverteilern keine weiteren Zusatzinformationen über Zusatzleitungen von außen zugeführt werden, sodass dieser quasi autark den Fehlerfall ermittelt bzw. diese quasi autark den Fehlerfall ermitteln und den betroffenen Leistungsausgang abschalten.

Als Fehlerfall ist hierbei insbesondere der Fall/der Betriebszustand vorgegeben, bei dem Leistung/Strom über einen Leistungsausgang aus dem Leistungsverteiler heraus fließt, während die Spannung am entsprechenden Leistungsausgang oder am Zwischenabgriff unterhalb eines vorgegebenen ersten Sollwerts liegt. Das heißt, dass der Fehlerfall insbesondere dann vorliegt, wenn ein sogenannter harter Kurzschluss auftritt. Die Abschaltung, Abtrennung oder Sperrung durch das Schalten des Abschaltelements soll daher sehr rasch erfolgen und dementsprechend ist ein hier vorgestellter Leistungsverteiler bevorzugt derart ausgebildet, dass die Reaktionszeit, also die Zeitdifferenz zwischen einem Abfall der Spannung an einem Leistungsausgang oder am Zwischenabgriff und der Sperrung oder dem Abschluss der Sperrung des entsprechenden Leistungsausgangs, kleiner etwa 10 ms ist, bevorzugt kleiner etwa 5 ms und insbesondere kleiner 1 ms. Ein entsprechender Leistungsverteiler ist daher typischerweise nicht geeignet zur Absicherung gegen sogenannte kriechende Kurzschlüsse wie sie beispielsweise in der DE 10 2009 027 387 A1 näher beschrieben sind. Außerdem ist der vorgegebene erste Sollwert bevorzugt ein Schwellwert, bei dessen Unterschreitung die Sperrung des entsprechenden Leistungsausgangs im Wesentlichen unabhängig davon erfolgt, wie lange die Unterschreitung anhält. Es sind also insbesondere nicht für verschiedene Unterschreitungszeiten unterschiedliche Schwellwerte, also Spannungswerte, vorgegeben, sondern lediglich ein Schwellwert.

Sind dann mehrere solcher Leistungsverteiler mit schaltbaren Leistungsausgängen mit verzögernd schaltenden Abschaltelementen, beispielsweise in einer Ringform oder in einer Strangform, zur Ausbildung eines Versorgungsnetzes miteinander verschaltet und über Leitungssegmente miteinander verbunden, so wird der Fehlerfall beim Auftreten eines Fehlers, beispielsweise eines harten Kurzschlusses, in einem Leitungssegment von den beiden daran angeschlossenen Leitungsverteilern am schnellsten ermittelt und die an das fehlerbehaftete Leitungssegment angeschlossenen schaltbaren Leistungsausgänge werden abgeschaltet. In der Folge ist dann das fehlerbehaftete Leitungssegment, also beispielsweise ein einen Spannungseinbruch verursachendes Leitungssegment, quasi isoliert, weswegen sich die Spannung im Übrigen Versorgungsnetz wieder stabilisiert, bevor weitere Abschaltelemente reagieren. Die Spannungsversorgung kann somit für das übrige Versorgungsnetz, also beispielsweise ein Bordnetz, durchgehend aufrecht erhalten werden. Dementsprechend werden dann an derartige Leistungsverteiler angeschlossene Steuergeräte nicht in einen Auto-Reset Betriebsmodus fallen und die eingangs beschriebenen Probleme werden nicht auftreten.

Ein hier beschriebener Leistungsverteiler ist weiter bevorzugt einfach gehalten, indem zum Beispiel auf eine zuvor genannte Zusatzleitung für Zusatzinformationen, also für eine Datenübermittelung, verzichtet wird, wodurch sich auf einfach Weise sehr zuverlässige Leitungsverteiler realisieren lassen und wodurch sich entsprechende Leistungsverteiler verhältnismäßig kostengünstig fertigen lassen.

Die genaue Ausgestaltung eines entsprechenden Leistungsverteilers ist dabei an den jeweiligen Anwendungsfall oder Verwendungszweck angepasst, wobei der Leistungsverteiler vorzugsweise für den Einsatz als Teil eines Bordnetzes eines Fahrzeuges zu Land, zu Wasser oder in der Luft und in jedem Fall für ein Gleichstrom-Versorgungsnetz, ausgelegt ist.

Dabei weist ein solcher Leistungsverteiler typischerweise einen Zwischenabgriff oder, insbesondere sofern der Leistungsverteiler beispielsweise für ein Bordnetz mit mehreren entsprechenden Leistungsverteilern ausgebildet ist, einen als Versorgungsausgang oder Versorgungsknoten ausgebildeten Zwischenabgriff beispielsweise zur Versorgung einer Anzahl elektrischer Verbraucher auf sowie zwei Leistungsausgänge (nächster IPDN/Batterie) als Versorgungsanschlüsse, die in der Regel als Leistungsanschlüsse ausgebildet sind und dementsprechend je nach Betriebsweise oder je nach Betriebszustand des Leistungsverteilers als Leistungseingänge oder als Leistungsausgänge dienen. Weiter weist der Leistungsverteiler für jeden Leistungsausgang eine Schalteinheit mit einem Schalter zur bedarfsweisen Sperrung des zugehörigen Leistungsausgangs auf, sodass ein an einen Leistungsausgang angeschlossenes Leitersegment, ein daran angeschlossenes Teilbordnetz oder eine daran angeschlossene elektrische Energiequelle bedarfsweise, also insbesondere in einem Fehlerfall, vom entsprechenden Leistungsverteiler abgekoppelt werden kann, wobei hierdurch zumindest ein Fließen von elektrischem Strom aus dem entsprechenden Leistungsausgang heraus unterbunden wird. Auf diese Weise sind die Leistungsausgänge als schaltbare Leistungsausgänge ausgebildet.

Hierbei ist jede dieser Schalteinheiten derart ausgebildet, dass eine Sperrung des zugehörigen Leistungsausgangs erfolgt, wenn bei einem Spannungsabfall am zugehörigen Leistungsausgang und/oder am Versorgungsausgang unter einen ersten Sollwert ein Fehlerfall ermittelt wird, wobei die Sperrung des zugehörigen Leistungsausgangs umso schneller erfolgt, je größer der entsprechende Spannungsabfall ist. Das heißt, dass die Schalteinheiten derart ausgebildet sind, dass deren Reaktionszeit vom Spannungsabfall am zugehörigen Leistungsausgang und/oder am Versorgungsausgang abhängt und umso kürzer ist, je größer der entsprechende Spannungsabfall ist.

Von einem Spannungsabfall wird dabei im Sinne dieser Anmeldung dann gesprochen, wenn die Spannung beispielsweise an einem Leistungsausgang von einer typischen Betriebsspannung oder Versorgungsspannung, typischerweise ein Wertebereich um eine sogenannte Nennspannung herum, ausgehend unter einen vorgegebenen Grenzwert, dem ersten Sollwert, fällt.

Als Fehlerfall ist zudem insbesondere der Fall/der Betriebszustand vorgegeben, bei dem Leistung/Strom über einen der Leistungsausgänge aus dem Leistungsverteiler heraus fließt oder bei dem Leistung/Strom über einen der Leistungsausgänge aus dem Leistungsverteiler heraus fließt, während die Spannung am entsprechenden Leistungsausgang und/oder am Versorgungsausgang unterhalb des vorgegebenen ersten Sollwerts liegt.

Wird weiter der Fehlerfall durch eine Schalteinheit ermittelt, so erfolgt ein Umschalten des zugehörigen Schalters und somit eine Sperrung des zugehörigen Leistungsausgangs.

Ist ein entsprechender Leistungsverteiler also beispielsweise für ein Bordnetz eines Kraftfahrzeuges ausgebildet, so ist das Bordnetz typischerweise für eine Nennspannung von 12 V ausgelegt und dementsprechend ist dann auch ein hierfür vorgesehener Leistungsverteiler für Nennspannung von 12 V ausgelegt. Die üblicherweise im Betrieb auftretenden Spannungs-Schwankungen und die tolerierbaren Abweichungen der von der Nennspannung ergeben dann einen Wertebereich um die Nennspannung, dessen niedrigster Wert als Grenze oder eben als erster Sollwert vorgegeben wird und im Leistungsverteiler vorgegeben ist zwischen dem Normalbetrieb mit einer Spannung oberhalb der Grenze und dem Fehlerfall bei einer Spannung unterhalb der Grenze. Bei einem Bordnetz mit einer Nennspannung von 12 V wird dementsprechend ein erster Sollwert vorgegeben, der, je nachdem welcher Wertebereich um die Nennspannung herum als tolerierbar angesehen werden soll, 2 V bis 7 V und insbesondere 3 V bis 5 V unter dem Wert der Nennspannung, also 12 V, liegt, also zum Beispiel ein erster Sollwert von 8,8 V. Das entsprechende Konzept lässt sich hierbei ohne Weiteres auch auf Bordnetze mit einer höheren Spannung, beispielsweise 24 V oder 48 V, übertragen, wobei der Toleranzbereich typischerweise geeignet angepasst wird.

Bevorzugt weist weiter jede Schalteinheit eine Spannungs-Überwachungs-Einheit zur Überwachung der Spannung am zugehörigen Leistungsausgang und/oder am Zwischenabgriff bzw. am Versorgungsausgang auf. Dabei ist vorzugsweise eine Komparatorschaltung Teil einer solchen Spannungs-Überwachungs-Einheit, mittels der die Spannung am zugehörigen Leistungseingang und/oder am Zwischenabgriff bzw. am Versorgungsausgang mit dem ersten Sollwert verglichen wird, der insbesondere als Referenzspannung für die Komparatorschaltung generiert wird und somit als Spannung vorliegt.

Alternativ weist der Leistungsverteiler lediglich eine Spannungs-Überwachungs-Einheit, insbesondere mit einer Komparatorschaltung, auf, mittels derer beide Leistungseingänge und/oder der Zwischenabgriff bzw. der Versorgungsausgang überwacht wird. In diesem Fall sind dann die beiden Schalteinheiten mit dieser Spannungs-Überwachungs-Einheit verknüpft.

Außerdem ist jeder Spannungs-Überwachungs-Einheit ein Verzögerungsglied, insbesondere ein RC-Glied, vorgeschaltet. Jedes Verzögerungsglied dient hierbei vor allem dazu, einen Spannungsabfall an der Spannungs-Überwachungs-Einheit, also zum Beispiel am Eingang einer Komparatorschaltung, gegenüber einem am zugehörigen Leistungsausgang und/oder am Zwischenabgriff bzw. am Versorgungsausgang auftretenden Spannungsabfall zeitlich zu verzögern, wobei die zeitliche Verzögerung umso ausgeprägter ist, je langsamer die Spannung am Versorgungsausgang abfällt und/oder je geringer der Spannungsabfall am entsprechenden Versorgungsausgang bzw. am Zwischenabgriff bzw. am Versorgungsausgang ausfällt. Auf diese Weise werden quasi spannungsabfall-abhängige Reaktionszeiten für die Schalteinheiten vorgegeben, ohne dafür mehrere spannungsabhängige Schaltbedingungen vorgeben zu müssen. Als Folge wird bevorzugt als Schaltbedingung für die Schalteinheiten lediglich ein Spannungsschwellwert vorgegeben oder es werden als Schaltbedingungen für die Schalteinheiten lediglich ein Spannungsschwellwert und die Stromrichtung vorgegeben. Die Schaltbedingung ist dabei nicht mit der Reaktionszeit gleichzusetzen.

Hierdurch lässt sich mit entsprechenden Leistungsverteilern beispielsweise ein Bordnetz aufbauen, bei dem stets nur diejenigen Leistungsausgänge gesperrt werden, die einer Fehlerquelle, also insbesondere einer Kurzschlussstelle, und somit quasi dem Ursprung des Spannungsabfall am nächsten liegen. Dabei wird der Umstand ausgenutzt, dass die Spannung infolge eines entsprechenden Fehlers zwar an allen Versorgungsknoten abfällt, die Tiefe der der Spannungseinbrüche an den Versorgungsknoten aber unterschiedlich ausfällt und davon abhängig ist, wie nah ein Versorgungsknoten am Ursprung des Spannungsabfall liegt.

Alternativ oder ergänzend hierzu weist eine jede Schalteinheit eine Stromrichtungs-Überwachungs-Einheit auf, mittels derer die Stromflussrichtung am entsprechenden Leistungsausgang überwacht wird, mit der also überwacht wird, ob über diesen Leistungsausgang Leistung/Strom in den Leistungsverteiler hinein fließt oder aus dem Leistungsverteiler herausfließt. Bevorzugt erfolgt dabei die Stromüberwachung indirekt durch eine Spannungsüberwachung, die darüber hinaus bevorzugt eine Komparatorschaltung aufweist, mittels derer beispielsweise die Spannungen vor und nach dem zugehörigen Schalter oder vor und nach einem Hilfswiderstand am entsprechenden Leistungsausgang miteinander verglichen werden.

Von Vorteil ist dabei insbesondere eine Ausführung des Leistungsverteilers, bei der jede Schalteinheit eine Spannungs-Überwachungs-Einheit mit einer Komparatorschaltung und eine Stromrichtungs-Überwachungs-Einheit mit einer Komparatorschaltung aufweist und bei der die Ausgänge der beiden Komparatorschaltungen einer Schalteinheit miteinander verknüpft sind, sodass der zu einer Schalteinheit gehöriger Leistungsausgang nur dann mittels des zugehörigen Schalter gesperrt wird, wenn Leistung/Strom über den entsprechenden Leistungsausgang aus dem Leistungsverteiler heraus fließt, während die Spannung am entsprechenden Leistungsausgang und/oder am Zwischenabgriff bzw. am Versorgungsausgang unterhalb des vorgegebenen ersten Sollwerts liegt. Die beiden Komparatorschaltungen werden hierzu bevorzugt über zumindest ein Logikgatter, welches beispielsweise als AND-Gatter ausgebildet ist, oder über eine Logikschaltung miteinander verknüpft, welche zum Beispiel aus AND-Gattern und OR-Gattern oder aus NAND-Gattern und NOR-Gattern aufgebaut ist. Alternativ dazu teilen sich die beiden Schalteinheiten eine gemeinsame Spannungs-Überwachungs-Einheit. In diesem Fall weist dann zweckdienlicherweise jede Schalteinheit eine Stromrichtungs-Überwachungs-Einheit mit einer Komparatorschaltung und zumindest ein Logikgatter auf, welches beispielsweise als AND-Gatter ausgebildet ist, und der Ausgang der gemeinsamen Spannungs-Überwachungs-Einheit ist mit beiden Schalteinheiten über diese beiden Logikgatter verknüpft.

Des Weiteren ist eine jede Schalteinheit vorteilhafterweise derart ausgestaltet, dass diese eine Sperrung nach ermitteltem Fehlerfall dauerhaft aufrecht erhält, zumindest bis die Sperrung über eine Reset-Schaltung und/oder durch einen manuellen Reset aufgehoben wird, in dem beispielsweise ein Reset-Signal über einen Rest-Eingang am Leistungsverteiler in den Leistungsverteiler eingespeist wird. Hierbei erfolgt dann beispielsweise nach einer Sperrung eine Fehlervalidierung durch einen Controller, zum Beispiel ein Prozessor oder eine programmierbare Steuereinheit, und gegebenenfalls wird nachfolgend eine Entsperrung vorgenommen, indem beispielsweise ein Reset-Signal durch den Controller in den Leistungsverteiler eingespeist wird. Alternativ ist ein entsprechender Reset-Eingang zum Beispiel als Buchse an einem Gehäuse des Leistungsverteilers ausgebildet oder die Reset-Schaltung weist einen Taster oder Schalter für eine manuelle Betätigung auf, wobei in diesem Fall eine manuelle Betätigung ein Zurücksetzen der Schalteinheit und somit ein Entsperren des dazugehörigen Leistungsausgang bedingt. Dabei wird davon ausgegangen, dass die Ermittlung des Fehlerfalls in der Regel nur dann erfolgt, wenn ein Defekt auftritt, der eine Reparaturmaßnahme notwendig macht, weswegen eine Entsperrung des entsprechenden Versorgungsausgangs erst dann erfolgen soll, wenn eine entsprechende Reparatur vorgenommen wurde. Dementsprechend soll der Reset dann beispielsweise durch einen Servicemitarbeiter im Rahmen einer Wartung vollzogen werden.

Außerdem ist einer Ausführungsvariante entsprechend der Leistungsverteiler derart ausgebildet, dass eine Art "Lock"-Funktion realisiert ist, mittels derer die Reaktionsfähigkeit der anderen Schalteinheit oder aller übrigen Schalteinheiten zeitweise, beispielsweise für eine Zeitdauer von etwa 100 bis etwa 300 µs, blockiert wird, sobald eine Schalteinheit aufgrund eines Fehlerfalls reagiert hat. Auf diese Weise lässt sich beispielsweise verhindern, dass eine Schalteinheit quasi auf Spannungsschwankungen reagiert, die durch eine andere Schalteinheit hervorgerufen werden, also durch den Sperrvorgang einer der Leistungseingänge. Dabei gilt es zu bedenken, dass durch das Sperren eines Leistungsausgangs im Schaltmoment Spannungspeaks ausgelöst werden können. Eine solche "Lock"-Funktion lässt sich hierbei beispielsweise durch Logik-Gatter realisieren und/oder durch eine Anpassung der zuvor genannten Logikschaltung.

Weiter erfolgt eine dauerhafte Sperrung bevorzugt mit Hilfe eines Setzspeichers in einer jeden Schalteinheit, der bei Ermittlung des Fehlerfalls in einen Zustand versetzt wird, durch den der zugehörigen Leistungsausgang gesperrt und nachfolgend gesperrt gehalten wird. Im einfachsten Fall handelt es sich dabei um einen einfachen quasi digitalen Speicher mit zwei Zuständen, wobei der eine Zustand die Sperrung des zugehörigen Leistungsausgang bedingt, während der andere Zustand die Entsperrung bedingt.

Ist ein solcher Setzspeicher einerseits und eine Reset-Schaltung andererseits vorgesehen, so ist es zweckdienlich, wenn die Reset-Schaltung direkt mit dem Setzspeicher verknüpft ist. Bei einem Reset-Vorgang wird dann beispielsweise der Setzspeicher, zum Beispiel ein Kondensator oder ein Logikbaustein, auf ein Massepotential gezogen, was dann einem Low-Zustand entspricht, der eine Entsperrung des zugehörigen Leistungsausgangs bedingt oder zumindest ermöglicht.

Zur Sperrung des Leistungsausgangs dagegen wird der Setzspeicher entsprechend in einen High-Zustand versetzt, in dem an den Setzspeicher eine von Massepotential einfach zu unterscheidende Spannung angelegt wird, beispielsweise 3 V.

Ein entsprechender Setzspeicher lässt sich dabei zudem problemlos in eine einfach Logikschaltung, wie die zuvor genannte, integrieren, die aus Logikgattern aufgebaut ist. Von Vorteil ist dabei beispielsweise eine Logikschaltung, bei der einem AND-Gatter ein OR-Gatter nachgeschaltet ist, wobei weiter bevorzugt der Setzspeicher mit einem Eingang des OR-Gatters verbunden ist. Alternativ oder ergänzend hierzu ist der Ausgang des OR-Gatters mit dem Setzspeicher verbunden, wobei der Ausgang des OR-Gatters weiter bevorzugt zur Ansteuerung des Schalters der entsprechenden Schalteinheit genutzt wird, der typischerweise durch einen oder mehrere Halbleiterschalter ausgebildet ist. An das zuvor genannte AND-Gatter lassen sich zudem vorteilhafterweise Komparatorschaltungen anbinden.

Außerdem ist eine Ausführung des Leistungsverteilers von Vorteil, bei der jede der Schalteinheiten eine Komparatorschaltung zur Spannungsüberwachung und eine Komparatorschaltung zur Stromrichtungsüberwachung aufweist, wobei die beiden Komparatorschaltungen ausgangsseitig über ein AND-Gatter miteinander verknüpft sind. Jenem AND-Gatter ist dann ein OR-Gatter nachgeschaltet, wobei ein Eingang des OR-Gatters mit einem zuvor genannten Setzspeicher verbunden ist, der gleichzeitig mit dem Ausgang des OR-Gatters verbunden ist. Zudem ist an den Ausgang des OR-Gatters direkt oder indirekt zumindest ein Halbleiterschalter angebunden, der in Abhängigkeit des Ausgangssignals am Ausgang des OR-Gatter gesperrt oder entsperrt ist. Alternativ dazu teilen sich wiederum die beiden Schalteinheiten eine gemeinsame Spannungs-Überwachungs-Einheit.

Unabhängig von der genauen Ausgestaltung der Schalteinheiten des Leistungsverteilers sind die Schalteinheiten bevorzugt als autarke Schalteinheiten ausgebildet, in dem Sinne, dass jede Schalteinheit eine isolierte, autarke Logikeinheit aufweist oder ausbildet, so dass eine Sperrung des zugehörigen Leistungsausgangs ohne eine Kommunikation mit anderen Schalteinheiten im entsprechenden Leistungsverteiler oder in anderen Leistungsverteilern erfolgt. Es wird hierbei insbesondere auf eine Datenschnittstelle in einem entsprechenden Leistungsverteiler verzichtet, über die dieser mit anderen Leistungsverteilern für einen Informationsaustausch verbindbar ist. Auch kommen die entsprechenden Schalteinheiten bevorzugt ohne Prozessoren oder programmierbare Steuereinheiten aus, weswegen die Schalteinheiten und letzen Ende auch der Leistungsverteiler einfach gehalten ist. Ist dagegen ein Prozessor oder eine programmierbare Steuereinheit, also beispielsweise ein Controller, vorhanden, so wird dieser bevorzugt nicht für die Fehlererkennung, Fehlerermittlung und/oder für ein Abschalten, insbesondere ein Sperren eines Leistungsausgangs, benötigt und/oder genutzt.

Hierbei ist es außerdem günstig, wenn ein entsprechender Leistungsverteiler oder eine jede Schalteinheit eine interne Spannungsversorgungs-Schaltung aufweist, die die Schalteinheiten bzw. die jeweilige Schalteinheit versorgt und bevorzugt spannungsstabilisierend wirkt. Dabei liegt die Versorgungsspannung der Schalteinheiten typischerweise unter der Nennspannung des Leistungsverteilers.

Wie bereits zuvor erwähnt, wird der Schalter einer jeden Schalteinheit durch zumindest einen Halbleiterschalter gebildet. Hierbei ist es zweckdienlich, wenn der Leistungsverteiler oder eine jede Schalteinheit zumindest eine Spannungspumpe zur Ansteuerung der Halbleiterschalter im Leistungsverteiler oder der Halbleiterschalter der jeweiligen Schalteinheit aufweist, durch welche die Halbleiterschalter für den Normalbetrieb entsperrt werden.

Soll der Schalter einer Schalteinheit für höhere Leistungen ausgelegt sein, so ist es außerdem zweckdienlich diesen durch mehrere parallel geschaltete Halbleiterschalter auszubilden, welche dann auch parallel angesteuert und somit parallel, also insbesondere zeitgleich, gesperrt und entsperrt werden. Die Halbleiterschalter einer Schalteinheit sind dabei bevorzugt gleichartig ausgestaltet.

Zudem ist es vorteilhaft für die Schalteinheiten des Leistungsverteilers und insbesondere für die Halbleiterschalter der Schalter einen Unterspannungsschutz vorzusehen, also insbesondere zumindest eine Schaltung, beispielsweise eine Komparatorschaltung, die eine Gateansteuerung erst zulässt, wenn die zur Verfügung stehende Versorgungsspannung ausreichend für eine volle Durchschaltung ist.

Des Weiteren ist es günstig, wenn die Schalteinheiten des Leistungsverteilers auf einer Leiterplatine realisiert sind und/oder wenn ein entsprechender Leistungsverteiler oder jede Schalteinheit des Leistungsverteilers zumindest einen Eingang für Ansteuer- und/oder Testsignale aufweist.

Weiter weist ein hier vorgestelltes Bordnetz je nach Anwendungszweck einen oder mehrere Leistungsverteiler auf, der bzw. die gemäß einer der zuvor beschriebenen Ausgestaltungsvarianten ausgebildet ist bzw. ausgebildet sind.

Gemäß einer Ausführungsvariante weist das Bordnetz dabei eine Anzahl sicherheitsrelevanter Verbraucher und eine Anzahl sonstiger Verbraucher sowie ein erstes Teilbordnetz und ein zweites Teilbordnetz auf, wobei das erste und das zweite Teilbordnetz über einen Leistungsverteiler miteinander verbunden oder verknüpft sind. Dabei sind die sicherheitsrelevanten Verbraucher bevorzugt zur redundanten Versorgung in beide Teilbordnetze eingebunden. Die sonstigen Verbraucher sind bevorzugt zur einfachen Versorgung jeweils in eines der beiden Teilbordnetze eingebunden und /oder an den Zwischenabgriff des Leistungsverteilers angebunden.

Das Bordnetz ist in diesem Fall dann quasi zweigeteilt und es sind bevorzugt keine weiteren Leistungsverteiler, also keine weiteren Leistungsverteiler dieser Ausgestaltung, vorgesehen und im Bordnetz eingesetzt. Eine derartige Ausgestaltung des Bordnetzes ist dabei insbesondere dann vorteilhaft, wenn die Anzahl sicherheitsrelevanter Verbraucher relativ gering ist und dementsprechend relativ wenige elektrische Verbraucher zweifach abgesichert sein sollen oder müssen. Als sicherheitsrelevante elektrische Verbraucher werden hierbei beispielsweise Steuereinheiten angesehen, mithilfe derer Fahrassistenzsysteme realisiert werden, die zur teilautomatisierten Steuerung eines Kraftfahrzeuges ausgebildet sind, die also in die Steuerung des Kraftfahrzeuges quasi eingreifen.

Gemäß einer vorteilhaften Weiterbildung sind weiter alle sonstigen Verbraucher in das erste Teilbordnetz eingebunden und dementsprechend dient dann das zweite Teilbordnetz ausschließlich zur zusätzlichen Absicherung der sicherheitsrelevanten Verbraucher oder aber es sind alle sonstigen Verbraucher an den Zwischenabgriff des Leistungsverteilers angebunden.

Einer alternativen Ausgestaltungsvariante entsprechend sind die sicherheitsrelevanten Verbraucher, also diejenigen elektrischen Verbraucher, die zur Realisierung einer sicherheitsrelevanten Funktion genutzt und dementsprechend eingesetzt werden, nicht zur redundanten Versorgung in beide Teilbordnetze eingebunden, stattdessen ist eine vergleichbarere Redundanz dadurch erreicht, dass die sicherheitsrelevanten Verbraucher doppelt vorhanden sind und zwar einmal im ersten Teilbordnetz und einmal im zweiten Teilbordnetz. Die beiden Prinzipien lassen sich dabei auch miteinander kombinieren, wobei in diesem Fall dann einige sicherheitsrelevante Verbraucher doppelt vorhanden und einige sicherheitsrelevante Verbraucher zur redundanten Versorgung in beide Teilbordnetzte eingebunden sind.

Bei einer derartigen Ausgestaltung eines Bordnetzes ist es je nach Anwendungszweck weiter von Vorteil, wenn die beiden Schalteinheiten des Leistungsverteilers räumlich voneinander getrennt sowie insbesondere in separaten Gehäusen angeordnet sind. In einem solchen Fall ist dann der Zwischenabgriff zweckdienlicherweise als Leiterverbindung oder Verteilerknoten ausgebildet, die bzw. der die beiden Schalteinheiten bzw. die beiden separaten Gehäuse insbesondere für einen Leistungsaustausch oder eine Leistungsübertragung elektrisch leitend miteinander verbindet.

In vorteilhafter Weiterbildung sind die beiden Schalteinheiten dann jeweils in einer sogenannten Sicherungsbox angeordnet, beispielsweise zusammen mit einer Stromverteilerschiene und/oder einer Anzahl von Schmelzsicherungen und/oder anderen Sicherungselementen, wie elektronischen Sicherungen.

Alternativ bilden mehrere Leistungsverteiler, die gemäß einer der zuvor genannten Ausführungsvarianten ausgestaltet sind, ein Bordnetz aus, wobei in diesem Fall dann bevorzugt an jedem Leistungsverteiler über dessen als Versorgungsausgang ausgebildeten Zwischenabgriff eine Anzahl an elektrischer Verbraucher angeschlossen ist. Bei einer derartigen Ausgestaltung des Bordnetzes sind dann die Leistungsverteiler typischerweise über ihre Leistungsausgänge und dazwischen liegende Verbindungsleiter untereinander verbunden, wobei beispielsweise an zwei Leistungsausgängen oder an zwei Zwischenabgriffen zweier Leistungsverteiler zwei elektrische Energiequellen für eine redundante Versorgung der elektrischen Verbraucher mit elektrischer Leistung angeschlossen sind, sodass bei einem Kurzschluss entlang einem der Verbindungsleiter dieser durch die angeschlossenen Verbindungsleiter elektrisch isoliert wird.

Die Leistungsverteiler bilden zudem weiter bevorzugt je nach Ausführungsvariante eine Verteilerkette aus, an deren Enden je eine elektrische Energiequelle angeschlossen ist oder aber die Leistungsverteiler bilden einen Verteilerring aus, wobei an zwei Leistungsverteilern jeweils eine elektrische Energiequelle angeschlossen ist.

Ausführungsbeispiele der Erfindung werden nachfolgend anhand einer schematischen Zeichnung näher erläutert. Darin zeigen:
- Fig. 1: in einem Blockschaltbild eine erste Ausführung eines Leistungsverteilers mit einer ersten Ausführung einer Steuereinheit,
- Fig. 2: in einem Blockschaltbild eine zweite Ausführung eines Leistungsverteilers mit einer zweiten Ausführung der Steuereinheit,
- Fig. 3: in einem Blockschaltbild eine erste Ausführung eines Bordnetzes mit mehreren Leistungsverteilern,
- Fig. 4: in einem Blockschaltbild eine zweite Ausführung des Bordnetzes mit mehreren Leistungsverteilern,
- Fig. 5: in einem Blockschaltbild eine dritte Ausführung des Bordnetzes mit einem Leistungsverteiler,
- Fig. 6: in einem Blockschaltbild eine vierte Ausführung des Bordnetzes mit einem Leistungsverteiler
- Fig. 7: in einem Blockschaltbild eine fünfte Ausführung des Bordnetzes mit einem Leistungsverteiler,
- Fig. 8: in einem Blockschaltbild eine sechste Ausführung des Bordnetzes mit einem Leistungsverteiler,
- Fig. 9: in einem Blockschaltbild eine dritte Ausführung der Steuereinheit,
- Fig. 10: in einem Blockschaltbild eine vierte Ausführung der Steuereinheit sowie
- Fig. 11: in einem Blockschaltbild eine fünfte Ausführung der Steuereinheit.

Einander entsprechende Teile sind in allen Figuren jeweils mit den gleichen Bezugszeichen versehen.

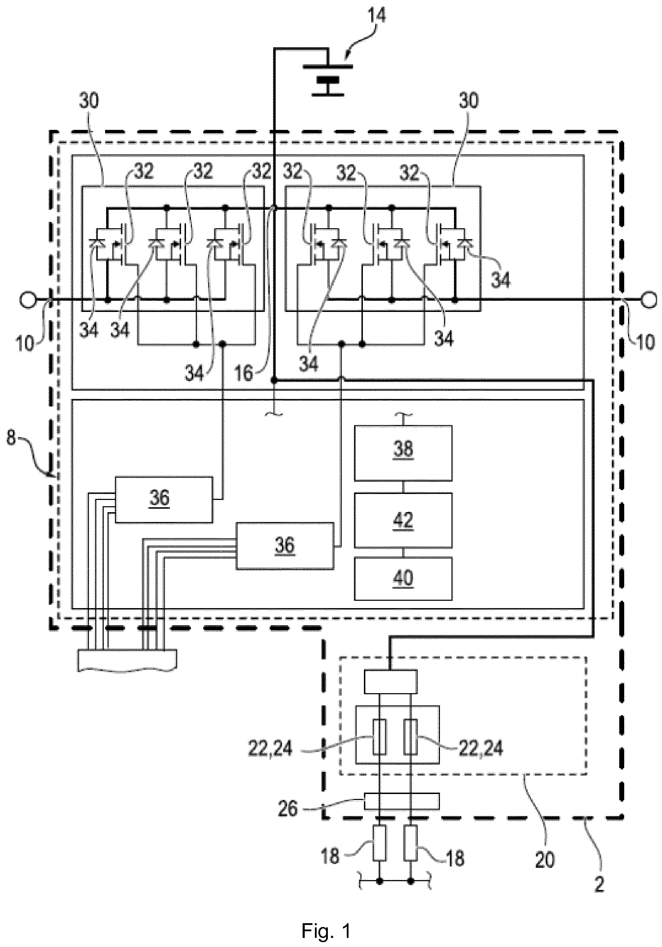

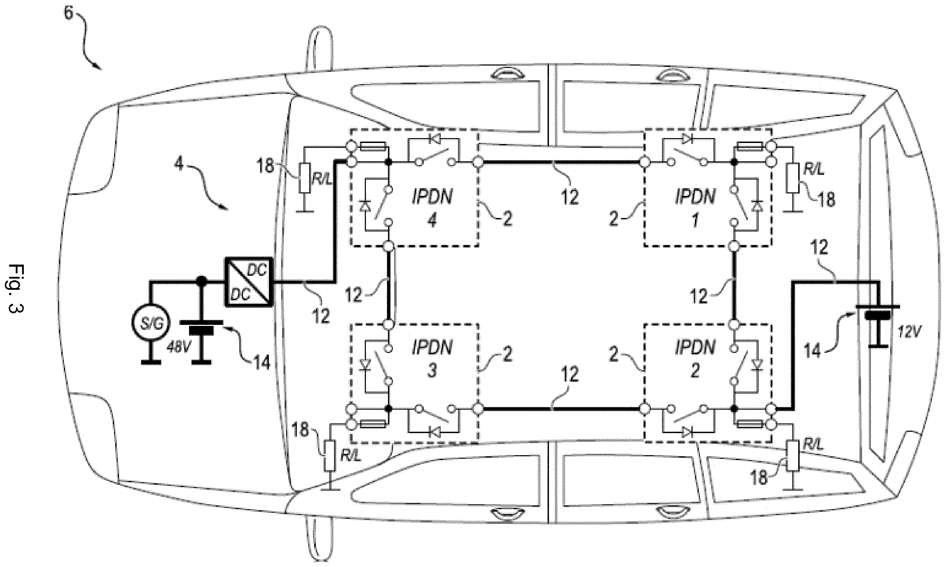

Ein nachfolgend exemplarisch beschriebener und in Fig. 1 skizzierter Leistungsverteiler 2 dient bevorzugt zur Ausbildung eines sogenannten Versorgungsknotens in einem in Fig. 3 bis Fig. 6 beispielhaft dargestellten Bordnetz 4 eines Kraftfahrzeuges 6.

Jener Leistungsverteiler 2 ist dabei im Ausführungsbeispiel gemäß Fig. 1 zumindest teilweise auf einer Leiterplatine 8 realisiert, welche in einem nicht mit abgebildeten Kunststoffgehäuse einliegt. Er weist zwei Leistungsausgänge 10 auf, die als Leistungsanschlüsse ausgebildet sind, sodass über einen entsprechenden Leistungsausgang 10 je nach Betriebssituation oder Betriebszustand des Leistungsverteilers 2 elektrische Leistung/elektrischer Strom in den Leistungsverteiler 2 hineinfließt oder aber elektrische Leistung/elektrischer Strom aus dem Leistungsverteiler 2 herausfließt. Im verbauten Zustand des Leistungsverteilers 2 sind die entsprechenden Leistungsausgänge 10 dann direkt oder indirekt über Leitungssegmente 12 mit weiteren Leistungsverteilern 2, mit anderen elektrischen Baugruppen und/oder mit elektrischen Energiequellen, beispielsweise einer Batterie 14, verbunden, so dass der Leistungsverteiler 2 insbesondere einen Versorgungsknoten in dem Bordnetz 4 des Kraftfahrzeuges 6 ausbildet.

Weiter weist der Leistungsverteiler 2 einen Zwischenabgriff 16 auf, der im Ausführungsbeispiel gemäß Fig. 1 als Versorgungsausgang 16 ausgebildet ist, der zwischen den beiden Leistungsausgängen 10 zwischengeschaltet ist und über den sich einer Anzahl elektrischer Verbraucher 18 im Betrieb des Leistungsverteilers 2 mit elektrischer Energie versorgen lassen. Hierzu ist der Versorgungsausgang 16 im Ausführungsbeispiel gemäß Fig. 1 als Verteilerblech 20 mit mehreren Anschlussarmen 22 ausgebildet, wobei bevorzugt in jeden Anschlussarm 22 nach an sich bekanntem Prinzip eine Schmelzsicherung 24 integriert ist. An jeden Anschlussarm 22 wiederum ist im Ausführungsbeispiel ein Steckverbinder 26 angeschlossen, an welchem sich ein elektrischer Verbraucher 18 über eine Steckverbindung anschließen lässt. Gemäß einer alternativen Ausführung bilden die Anschlussarme 22 gemeinsam die Steckkontakte eines einzigen Steckverbinders 26 aus.

Außerdem weist der Leistungsverteiler 2 eine Schalteinheit 28 mit einem Schalter 30 für jeden Leistungsausgang 10 auf, die im Bedarfsfall eine Sperrung des zugehörigen Leistungsausgangs 10 ermöglicht.

Ein entsprechender Schalter 30 ist dabei im Ausführungsbeispiel gemäß Fig. 1 durch drei parallel geschaltete Halbleiterschalter 32 ausgebildet, wobei parallel zu jedem Halbleiterschalter 32 eine Sperrdiode 34 geschaltet ist. Die Halbleiterschalter 32 sind dabei im Wesentlichen identisch ausgestaltet und für schnelle Schaltvorgänge ausgelegt. Bevorzugt werden hierbei Halbleiterschalter 32 eingesetzt, die sich innerhalb einiger µs sperren lassen, also in 10 bis 100 µs.

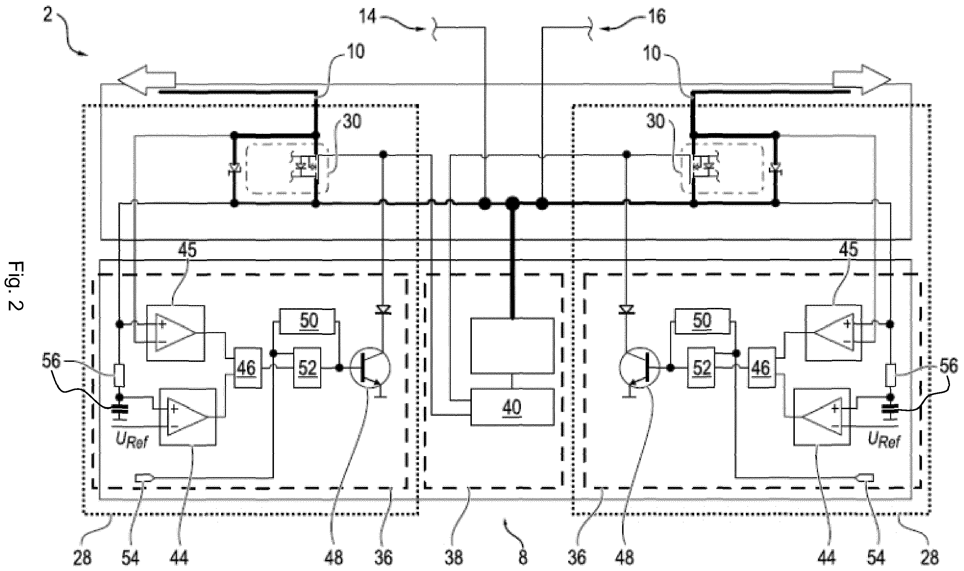

Dabei sind insbesondere für Anwendungsfälle mit größerem Leistungsbedarf Schalter 30 mit mehreren parallel geschalteten Halbleiterschaltern 32 vorgesehen, auf die sich die entsprechende Leistung verteilt. Im Falle eines geringeren Leistungsbedarfs und/oder in Fällen, in denen die Anforderungen an die Schaltgeschwindigkeit geringer ausfallen, lässt sich ein entsprechender Schalter 30 gegebenenfalls mithilfe nur eines Halbleiterschalters 32 realisieren und es wird in solchen Fällen dann auch auf die Verwendung mehrerer Halbleiterschalter 32 verzichtet. Ein entsprechendes Ausführungsbeispiel, bei dem jeder Schalter 30 durch einen einzigen Halbleiterschalter 32 mit parallel geschalteter Sperrdiode 34 realisiert ist, ist in Fig. 2 wiedergegeben.

Teil einer jeden Schalteinheit 28 ist außerdem eine Steuereinheit 36, mittels derer der Schalter 30 der entsprechenden Schalteinheit 28 angesteuert wird und mittels derer festgelegt wird, ob der zugehörige Schalter 30 und somit der zugehörige Leistungsausgang 10 gesperrt oder entsperrt ist. Im Ausführungsbeispiel sind dabei die Steuereinheiten 36 des Leistungsverteilers 2 einerseits und die Schalter 30 des Leistungsverteilers 2 andererseits auf verschiedenen Seiten der Leiterplatine 8 realisiert und über Durchkontaktierungen miteinander verbunden. Einer alternativen Variante entsprechend sind die Steuereinheiten 36 einerseits und die Schalter 30 andererseits auf verschiedenen Leiterplatinen 8 realisiert, die dann beispielsweise über Leitungen miteinander verbunden sind oder aber die Schalteinheiten 28 des Leistungsverteilers 2 sind als Ganzes auf einer Seite einer Leiterplatine 8 realisiert.

Außerdem sind die Schalteinheiten 28 im Ausführungsbeispiel derart ausgebildet, dass die Halbleiterschalter 32 der Schalter 30 in einem Ausgangszustand ohne eine dem Leistungsverteiler 2 von außen zugeführte oder zur Verfügung gestellte Versorgungsspannung gesperrt sind und dementsprechend für einen Betrieb oder Normalbetrieb des Leistungsverteilers 2 im Bordnetz 4 entsperrt werden müssen. Hierzu wird die im Normalbetrieb über die Leistungsausgänge 10 zur Verfügung stehende elektrische Spannung genutzt, wobei aus dieser mittels einer internen Spannungsversorgungs-Schaltung 38 mit einer Spannungspumpe 40 eine Versorgungsspannung für die Schalteinheiten 28 und insbesondere für die Schalter 30 generiert wird, welche die Halbleiterschalter 32 der Schalter 30 insbesondere zeitgleich entsperrt. Die Spannungsversorgung der Halbleiterschalter 32 der Schalter 30 über die Spannungsversorgungs-Schaltung 38 wird dabei typischerweise permanent aufrechterhalten und dementsprechend sind die Halbleiterschalter 32 in der Regel entsperrt, sobald ein entsprechender Leistungsverteiler 2 erst einmal im Kraftfahrzeuges 6 verbaut und an eine elektrische Energiequelle, beispielsweise eine Batterie 14, angeschlossen ist. In einigen Fällen weist die entsprechende interne Spannungsversorgungs-Schaltung 38 hierbei zudem einen Unterspannungsschutz 42 auf, der die Versorgungsspannung für die Schalteinheiten 28 und insbesondere für die Schalter 30 erst dann freigibt, wenn die Versorgungsspannung ausreicht um insbesondere sämtliche Halbleiterschalter 32 vollständig durchzuschalten.

Sind die Halbleiterschalter 32 und somit die Schalter 30 entsperrt, so erfolgt durch die Schalteinheiten 28 eine Überwachung der zugehörigen Leistungsausgänge 10, wobei im Falle der Ermittlung eines Fehlerfalls an einem Leistungsausgang 10 durch die zugehörige Schalteinheit 28 der entsprechende Leistungsausgang 10 gesperrt wird, in dem der zugehörige Schalter 30 angesteuert und hierdurch gesperrt wird. Im gesperrten Zustand ist dann ein Stromfluss über den entsprechenden Leistungsausgang 10 aus dem Leistungsverteiler 2 heraus unterbunden.

Der Fehlerfall liegt dabei an einem Leistungsausgang 10 vor, wenn Leistung/Strom über diesen Leistungsausgang 10 aus dem Leistungsverteiler 2 heraus fließt, während die Spannung am entsprechenden Leistungsausgang 10 unterhalb eines vorgegebenen ersten Sollwerts liegt. Dementsprechend werden durch die Schalteinheiten 28 die Spannungen und Stromrichtungen an den Leistungsausgängen 10 überwacht.

Im Ausführungsbeispiel gemäß Fig. 2 erfolgt die Überwachung der Spannungen an den Leistungsausgängen 10 dabei indirekt durch eine Überwachung der Spannung am Zwischenabgriff 16 bzw. am Versorgungsausgang 16, wobei davon ausgegangen wird, dass die Spannung am Zwischenabgriff 16 bzw. am Versorgungsausgang 16 bei geschlossenem Halbleiterschaltern 32 mit den Spannungen an den Leistungsausgängen 10 vergleichbar ist. Gemäß einer alternativen Ausgestaltung erfolgt dagegen eine direkte Überwachung der Spannungen unmittelbar an den entsprechenden Leistungsausgängen 10.

Eine entsprechende Spannungsüberwachung erfolgt dabei durch eine Spannungs-Überwachungs-Einheit 44, mit Hilfe derer sich Spannungsabfälle am Zwischenabgriff 16 bzw. am entsprechenden Versorgungsausgang 16 detektieren lassen. Fällt die überwachte Spannung dann in Betrieb des Leistungsverteilers 2 ausgehend von einer Versorgungsspannung oder Nennspannung von beispielsweise etwa 12 Volt unter einen vorgegebenen ersten Sollwert von beispielsweise 9 Volt, so ist hierdurch durch die Schalteinheit 28 die erste Bedingung für den Fehlerfall ermittelt.

Dabei wird bei der Vorgabe des ersten Sollwertes berücksichtigt, dass die Spannung in einem Bordnetz 4 typischerweise lokal variiert und/oder zeitlichen Schwankungen unterliegt. Diese Abweichungen werden jedoch als unproblematisch angesehen und sollen dementsprechend auch nicht zur Ermittlung des Fehlerfalls führen. Gleichzeitig ist es jedoch gewünscht, dass der Leistungsverteiler 2 oder vielmehr die Schalteinheiten 28 möglichst schnell auf Störungen im Bordnetz 4 reagieren und zwar auch dann, wenn eine Störung, also beispielsweise das Auftreten eines Defekts bei einem Bauteil im Bordnetz 4, nicht zu einem völligen Zusammenbruch der Versorgungsspannung im Bordnetz 4 führt, also zu einem Abfall der Spannung an einem Leistungsausgang 10 auf einen Wert im Bereich eines Massepotentials. Ein erster Sollwert der etwa 20% unter der sogenannten Nennspannung liegt stellt dabei einen vorteilhaften Kompromiss dar.

Weiter erfolgt durch die Schalteinheiten 28 im Ausführungsbeispiel zusätzlich zur Überwachung der Spannung eine Überwachung der Stromrichtung am zugehörigen Leistungsausgang 10 mit Hilfe einer Stromrichtungs-Überwachungs-Einheit 45. Hierbei wird die Stromrichtung indirekt über eine Spannungsdifferenz ermittelt, wobei hierzu wiederum eine Komparatorschaltung genutzt wird, welche die Potentiale vor und nach dem zugehörigen Schalter 30 miteinander vergleicht. Die zweite Bedingung ist dann erfüllt, wenn Strom über den zugehörigen Leistungsausgang 10 aus dem Leistungsverteiler 2 herausfließt.

Der Fehlerfall liegt jedoch im Ausführungsbeispiel nur dann vor, wenn beide Bedingungen erfüllt sind, wenn also eine Schalteinheit 28 ermittelt, dass Strom über den zugehörigen Leistungsausgang 10 aus dem Leistungsverteiler 2 herausfließt, während die Spannung am zugehörigen Leistungsausgang 10 unter dem ersten Sollwert liegt. Die beiden Komparatorschaltungen einer jeden Schalteinheit 28 sind daher, wie im Ausführungsbeispiel gemäß Fig. 2 dargestellt, ausgangsseitig über eine einfache Logik miteinander verknüpft, also hier einem AND-Gatter 46.

Der zugehörige Schalter 30 wird dabei gesperrt, indem ein dem AND-Gatter 46 nachgeschalteter Halbleiterschalter 48 entsperrt und hierdurch das Potential am Gate des Halbleiterschalters 32 des Schalters 30 auf ein Massepotential oder ein Source-Potential gezogen wird. Einmal entsperrt wird der dem AND-Gatter 46 nachgeschaltete Halbleiterschalter 48 mittels eines Setzspeichers 50 dauerhaft entsperrt gehalten, wodurch schließlich der zugehörige Schalter 30 dauerhaft gesperrt bleibt. Hierzu ist dem AND-Gatter ein OR-Gatter 52 nachgeschaltet, welches sowohl eingangsseitig als auch ausgangsseitig mit dem Setzspeicher 50 verbunden ist. Eine Rücksetzung des Setzspeichers 50, der beispielsweise als Kondensator ausgebildet ist, und infolgedessen eine Sperrung des nachgeschalteten Halbleiterschalters 48 und schließlich eine Entsperrung des zugehörigen Schalters 30 ist im Ausführungsbeispiel dann nur möglich, indem der Setzspeicher 50 zusammen mit dem zugehörigen Eingang am OR-Gatter 52 über einen Reset-Kontakt 54 auf ein Massepotential oder ein Source-Potential gezogen wird.

Zusätzlich zum Reset-Kontakt 54 weist der Leistungsverteiler 2 oder eine jede Schalteinheit 28 je nach Ausführungsvariante weitere Ansteuer- und Test-Kontakte oder Kontaktanschlüsse auf, die es erlauben verschiedene Signale einzuspeisen und/oder auszulesen, um beispielsweise den Zustand des Leistungsverteilers 2 bzw. der jeweiligen Schalteinheit 28 zu ermitteln, also insbesondere ob im Leistungsverteiler 2 bzw. in der jeweiligen Schalteinheit 28 ein Defekt vorliegt oder nicht. Hierzu wird dann beispielsweise im Rahmen einer Wartung des Kraftfahrzeuges ein Testgerät über die Kontakte bzw. Kontaktanschlüsse an den Leistungsverteiler 2 bzw. an die jeweilige Schalteinheit 28 angeschlossen. Auch die Rücksetzung des Setzspeichers 50 erfolgt typischerweise im Rahmen einer Wartung des Kraftfahrzeuges 6, und zwar nachdem die Störung, die zum Setzen des Setzspeichers 50 und somit zur Sperrung des zugehörigen Schalters 30 geführt hat, beseitigt worden ist.

Weiter ist jeder Spannungs-Überwachungs-Einheit 44 bevorzugt ein Verzögerungsglied vorgeschaltet, welches beispielsweise als RC-Glied 56 ausgestaltet ist. Hierdurch wird ein Spannungsabfall am Eingang der Spannungs-Überwachungs-Einheit 44, also im Ausführungsbeispiel am Eingang der entsprechenden Komparatorschaltung, gegenüber einem am zugehörigen Leistungsausgang 10 bzw. am Zwischenabgriff bzw. am Versorgungsausgang 16 auftretenden Spannungsabfall zusätzlich verzögert, wobei die Verzögerung umso größer ausfällt, je geringer oder je langsamer der Spannungsabfall am Leistungsausgang 10 bzw. am Versorgungsausgang 16 ist.

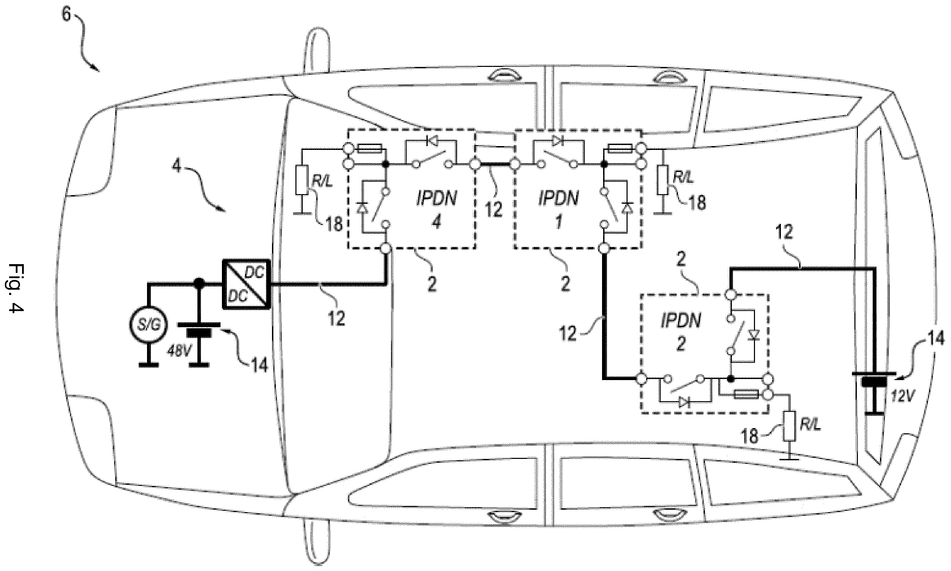

Mit einem solchen Leistungsverteiler 2 lässt sich dann auch ein vorteilhaftes, redundantes Bordnetz 4 realisieren, in dem gemäß einer Ausführungsvariante mehrere Leistungsverteiler 2 beispielsweise in einer Ringform, sowie in Fig. 3 dargestellt, oder in einer Strangform, sowie in Fig. 4 dargestellt, angeordnet werden und mit zwei unabhängigen elektrischen Energiequellen, also insbesondere zwei Batterien 14, verbunden werden.

Tritt dann in einem der Leitungssegmente 12 beispielsweise ein Kurzschluss auf oder ein anderer einen signifikanten Spannungsabfall verursachender Defekt, so werden stets nur diejenigen Schalter 30 gesperrt, die entlang der Strompfade gesehen dem Defekt am nächsten sind, also am dichtesten an der Fehlerquelle positioniert sind, wodurch das entsprechende Leitungssegment 12 isoliert wird. Nach einer entsprechenden Isolierung eines Leitungssegments 12 sind jedoch alle Leitungsverteiler 2 weiterhin mit zumindest einer Batterie 14 verbunden, sodass die Versorgung der an die Leitungsverteiler 2 angeschlossenen elektrischen Verbraucher 18 weiterhin sichergestellt ist.

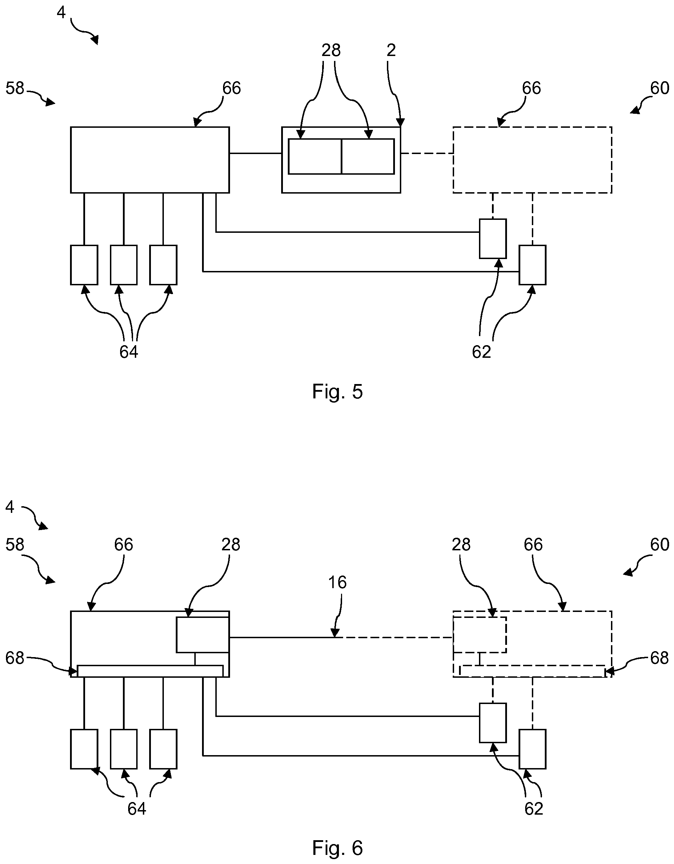

Einer alternativen Ausführungsvariante entsprechend wird das Bordnetz 4 mit lediglich einem derartigen, zuvor beschriebenen Leistungsverteiler 2 realisiert, wobei das Bordnetz 4 in diesem Fall bevorzugt quasi zweiteilig aufgebaut ist und dementsprechend ein erstes Teilbordnetz 58 und ein zweites Teilbordnetz 60 aufweist. Ein Ausführungsbeispiel hierzu ist in Fig. 5 schematisch wiedergegeben, wobei das zweite Teilbordnetz 60 gestrichelt dargestellt ist.

Hierbei dient das erste Teilbordnetz 58 zur Versorgung einer Anzahl sicherheitsrelevanter elektrischer Verbraucher 62 sowie einer Anzahl sonstiger elektrischer Verbraucher 64, wohingegen das zweite Teilbordnetz 60 ausschließlich zur Versorgung der sicherheitsrelevanten elektrischen Verbraucher 62 ausgebildet ist, so dass diese durch eine zweite Versorgungsmöglichkeit zusätzlich abgesichert sind. Das heißt, dass lediglich für die sicherheitsrelevanten elektrischen Verbraucher 62 eine redundante Versorgung vorgesehen ist.

Dabei sind die beiden Teilbordnetze 58, 60 über den einen Leistungsverteiler 2 miteinander verbunden oder verknüpft und dementsprechend werden die beiden Teilbordnetze 58, 60 im Fehlerfall, also im Fall eines zuvor beschriebenen Fehlers, voneinander getrennt, wodurch lediglich eines der beiden Teilbordnetze 58, 60 ausfällt und die Versorgung der sicherheitsrelevanten elektrischen Verbraucher 62 durch das jeweilige andere Teilbordnetz 58, 60 weiterhin sichergestellt ist.

In einer modifizierten Variante des Bordnetzes 4 gemäß Fig. 5 werden beide Teilbordnetze 58, 60 zur Versorgung sonstiger elektrischer Verbraucher 64 genutzt, allerdings sind die sonstigen elektrischen Verbraucher 64 auch hier bevorzugt jeweils nur an eines der beiden Teilbordnetze 58, 60 angebunden, so dass die entsprechenden sonstigen elektrischen Verbraucher 64 ausfallen, wenn das dazugehörige Teilbordnetz 58, 60 ausfällt.

Eine Abwandlung des Bordnetzes 4 gemäß Fig. 5 ist in Fig. 6 wiedergegeben, wobei in diesem Fall die beiden Schalteinheiten 28 des Leistungsverteilers 2 räumlich voneinander getrennt und in zwei separaten Gehäusen angeordnet sind. Hierbei ist jede der beiden Schalteinheiten 28 bevorzugt Teil einer sogenannten Sicherungsbox 66, in der eine sogenannte Stromverteilerschiene 68 angeordnet ist sowie typischerweise eine Anzahl Sicherungselemente, beispielsweise Schmelzsicherungen und/oder elektronische Sicherungen. Bei dieser Ausführungsvariante ist der Leistungsverteiler 2 quasi halbiert und jedes der beiden Gehäuse bzw. jede Sicherungsbox weist quasi einen halben Leistungsverteiler 2 auf.

Die beiden Sicherungsboxen 66 mit den darin enthaltenen Schalteinheiten 28 sind weiterhin zweckdienlicherweise über den Zwischenabgriff 16 des Leistungsverteilers 2 für einen Leistungsaustausch oder eine Leistungsübertragung elektrisch leitend miteinander verbunden, wobei in diesem Fall der Zwischenabgriff 16 beispielsweise als Leiterverbindung oder Kabelverbindung ausgestaltet ist. Eine der beiden Sicherungsboxen 66 ist hierbei beispielsweise im Frontbereich des Kraftfahrzeuges 6 angeordnet und die andere der beiden Sicherungsboxen 66 ist dann zum Beispiel im Heckbereich des Kraftfahrzeuges 6 angeordnet.

Außerdem weist bei dieser Ausführung jede Schalteinheit 28 bevorzugt eine eigene interne Spannungsversorgungs-Schaltung 38 auf.

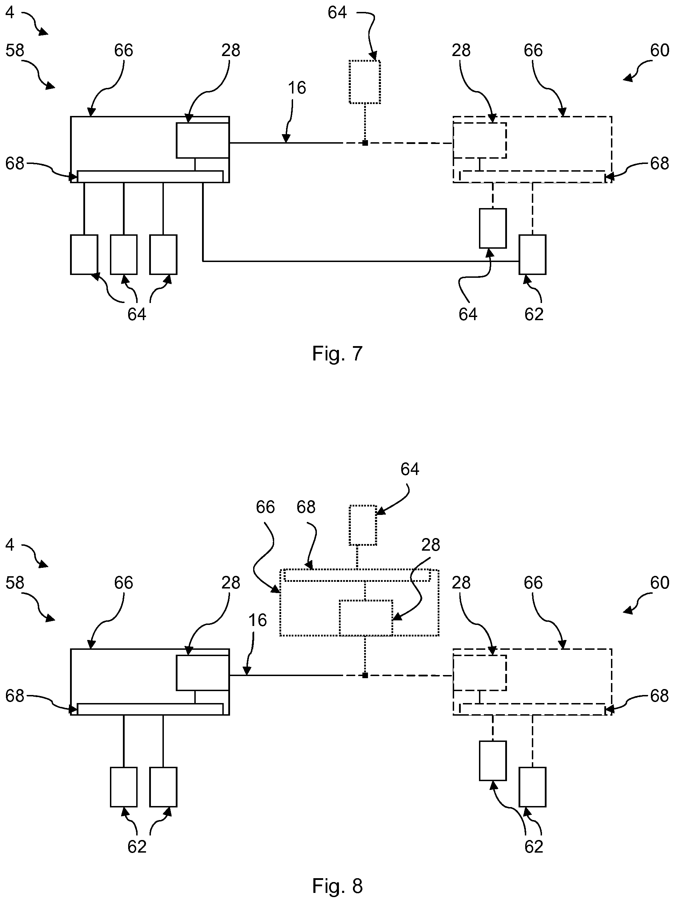

In Fig. 7 ist eine weitere Variante des Bordnetzes 4 gezeigt, die ähnlich der Ausführungsvariante gemäß Fig. 6 aufgebaut ist. Allerdings sind hier in beide Teilbordnetze 58, 60 jeweils sonstige elektrische Verbraucher 64 eingebunden und zudem ist ein sonstiger elektrischer Verbraucher 64 zur Versorgung an den Zwischenabgriff 16 angebunden.

Alternativ zur redundanten Versorgung der sicherheitsrelevanten elektrischen Verbraucher 62 lässt sich eine Redundanz auch dadurch erreichen, dass die sicherheitsrelevanten elektrischen Verbraucher 62 doppelt verbaut werden und zwar derart, dass jeder sicherheitsrelevante elektrische Verbraucher 62 einmal im ersten Teilbordnetz 58 und einmal im zweiten Teilbordnetz 60 vorhanden ist. Eine derartige Bordnetzausführung ist in Fig. 8 angedeutet. Zudem sind im Falle dieser Ausführungsvariante alle sonstigen elektrischen Verbraucher 64 an den Zwischenabgriff 16 angebunden. Diese Anbindung ist dabei als indirekte Anbindung ausgestaltet, wobei zwischen den Zwischenabgriff 16 und den sonstigen elektrischen Verbrauchern 64 eine zusätzliche Sicherungsbox 66 mit einer zusätzlichen Schalteinheit 28 zwischengeschaltet ist. In diesem Fall weist der Leistungsverteiler 2 dann quasi drei Schalteinheiten 28 auf.

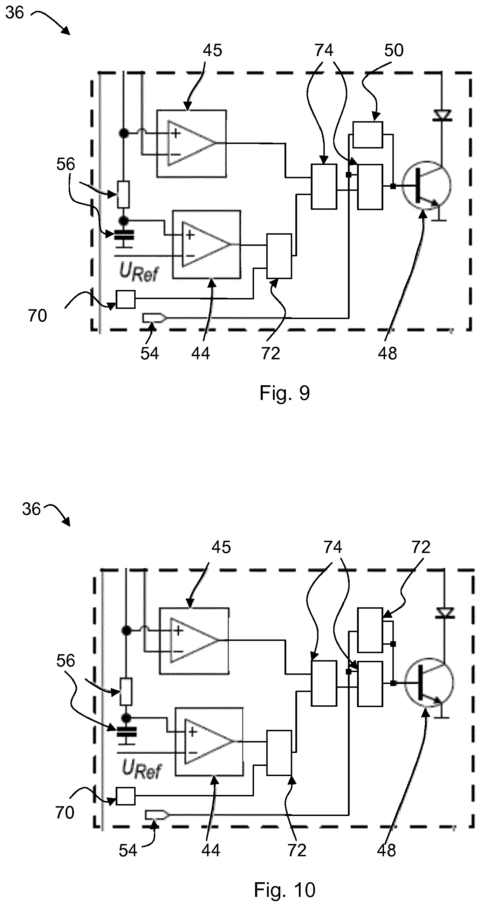

In den Darstellungen Fig. 9 sowie Fig. 10 sind schließlich zwei alternative Ausführungen der Steuereinheit 36 wiedergegeben. Bei diesen Ausführungen ist die Logikschaltung nicht durch AND-Gatter 46 und OR-Gatter 52 aufgebaut sondern mit Hilfe von NAND-Gattem 72 und NOR-Gattern 74.

Darüber hinaus ist bei diesen Ausführungen der Steuereinheit 36 eine sogenannte "Lock"-Funktion realisiert, die es ermöglicht, die Reaktionsfähigkeit einer Schalteinheit 28, die eine solche Steuereinheit 36 aufweist, zumindest zeitweise, also beispielsweise für eine Zeitdauer von etwa 100 bis etwa 300 µs, zu blockieren. Dazu wird dann beispielsweise über einen "Lock"-Eingang 70 ein Schaltsignal oder Steuersignal der Logikschaltung der Steuereinheit 36 der Schalteinheit 28 derart zugeführt, dass der Halbleiterschalter 48 unabhängig von der mittels der Spannungs-Überwachungs-Einheit 44 überwachten Spannung zumindest zeitweise nicht mehr entsperrt werden kann und dementsprechend der zugehörige Schalter 30 der Schalteinheit 28 nicht gesperrt werden kann.

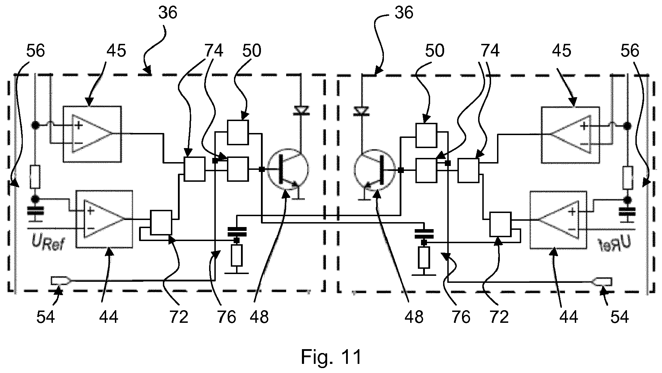

Typischerweise soll dabei die Reaktionsfähigkeit einer Schalteinheit 28 genau dann blockiert werden, wenn eine weitere Schalteinheit 28 desselben Leistungsverteilers 2 aufgrund eines Fehlerfalls reagiert hat oder gerade reagiert. Daher sind im Ausführungsbeispiel gemäß Fig. 11 die Logikschaltungen zweier Steuereinheiten 36 zweier Schalteinheiten 28 eines Leistungsverteilers 2 zur Realisierung einer solchen "Lock"-Funktion miteinander verknüpft. Die Logikschaltungen der beiden Steuereinheiten 36 sind dabei, von der Verknüpfung abgesehen, entsprechend der Logikschaltung der Steuereinheit 36 gemäß Fig. 9 ausgestaltet. Zur Ausbildung der Verknüpfung ist hierbei bei beiden Steuereinheiten 36 jeweils der Ausgang des NOR-Gatters 74, welches den zugehörigen Halbleiterschalter 48 der jeweiligen Steuereinheit 36 ansteuert, über ein RC-Glied 76 mit einem Eingang des NAND-Gatters 72 der jeweils anderen Steuereinheit 36 verbunden, welches der zugehörigen Spannungs-Überwachungs-Einheit 44 nachgeschaltet ist. Als Folge blockiert dann quasi ein Schaltsignal oder Steuersignal, welches in einer der Steuereinheiten 36 des Leistungsverteilers 2 den zugehörigen Halbleiterschalter 48 entsperrt, gleichzeitig eine Entsperrung des Halbleiterschalters 48 der anderen Steuereinheit 36 des Leistungsverteilers 2.

### Bezugszeichenliste

- 2: Leistungsverteiler
- 4: Bordnetz
- 6: Kraftfahrzeug
- 8: Leiterplatine
- 10: Leistungsausgang
- 12: Leitungssegment
- 14: Batterie
- 16: Zwischenabgriff/Versorgungsausgang
- 18: elektrischer Verbraucher
- 20: Verteilerblech
- 22: Anschlussarm
- 24: Schmelzsicherung
- 26: Steckverbinder
- 28: Schalteinheit
- 30: Schalter
- 32: Halbleiterschalter
- 34: Sperrdiode
- 36: Steuereinheit
- 38: interne Spannungsversorgungs-Schaltung
- 40: Spannungspumpe
- 42: Unterspannungsschutz
- 44: Spannungs-Überwachungs-Einheit
- 45: Stromrichtungs-Überwachungs-Einheit
- 46: AN D-Gatter
- 48: Halbleiterschalter
- 50: Setzspeicher
- 52: OR-Gatter
- 54: Reset-Kontakt
- 56: RC-Glied
- 58: erstes Teilbordnetz
- 60: zweites Teilbordnetz
- 62: sicherheitsrelevanter elektrischer Verbraucher
- 64: sonstiger elektrischer Verbraucher
- 66: Sicherungsbox
- 68: Stromverteilerschiene
- 70: "Lock"-Eingang
- 72: NAND-Gatter
- 74: NOR-Gatter
- 76: RC-Glied

## Patentansprüche

1. Leistungsverteiler (2), insbesondere für ein Bordnetz (4) eines Kraftfahrzeuges (6), aufweisend zwei Leistungsausgänge (10), einen Zwischenabgriff (16), und je eine Schalteinheit (28) für jeden Leistungsausgang (10) mit einem Schalter (30) zur bedarfsweisen Sperrung des zugehörigen Leistungsausgangs (10), wobei
- jede dieser Schalteinheiten (28) derart ausgebildet ist, dass eine Sperrung des zugehörigen Leistungsausgangs (10) erfolgt, wenn bei einem Spannungsabfall am zugehörigen Leistungsausgang (10) und/oder am Zwischenabgriff (16) unter einen ersten Sollwert ein Fehlerfall ermittelt wird, wobei die Sperrung des zugehörigen Leistungsausgangs (10) umso schneller erfolgt, je größer der entsprechende Spannungsabfall ist,
- jede dieser Schalteinheiten (28) mit einer Spannungs-Überwachungs-Einheit (44) verknüpft ist, mittels derer die Spannungen an den Leistungsausgängen (10) und/oder die Spannung am Zwischenabgriff (16) überwacht wird, oder wobei jede dieser Schalteinheiten (28) eine Spannungs-Überwachungs-Einheit (44) aufweist, mittels derer die Spannung am zugehörigen Leistungsausgang (10) und/oder am Zwischenabgriff (16) überwacht wird und
- jeder Spannungs-Überwachungs-Einheit (44) ein Verzögerungsglied (56) vorgeschaltet ist, so dass ein Spannungsabfall am zugehörigen Leistungsausgang (10) und/oder am Zwischenabgriff (16) einen Spannungsabfall mit verändertem zeitlichen Verlauf an der jeweiligen Spannungs-Überwachungs-Einheit (44) bedingt.

2. Leistungsverteiler (2) nach Anspruch 1,
**dadurch gekennzeichnet,**
**dass** dieser derart ausgebildet ist, dass in einem Fehlerfall der jeweils am direktesten mit der Fehlerquelle verbundene Leistungsausgang und insbesondere lediglich der jeweils am direktesten mit der Fehlerquelle verbundene Leistungsausgang gesperrt wird.

3. Leistungsverteiler (2) nach Anspruch 1 oder 2,
**dadurch gekennzeichnet,**
**dass** der Zwischenabgriff (16) als Verteilerknoten oder als Versorgungsausgang (16) zur Versorgung einer Anzahl elektrischer Verbraucher (18) ausgebildet ist.

4. Leistungsverteiler (2) nach einem der Ansprüche 1 bis 3,
**dadurch gekennzeichnet,**
**dass** jede Spannungs-Überwachungs-Einheit (44) eine Komparatorschaltung (44) aufweist, mittels derer die Spannung am zugehörigen Leistungsausgang (10) und/oder am Zwischenabgriff (16) mit einer generierten Referenzspannung verglichen wird, wobei die Referenzspannung (U_{Ref}) dem ersten Sollwert entspricht.

5. Leistungsverteiler (2) nach einem der Ansprüche 1 bis 4,
**dadurch gekennzeichnet,**
**dass** jede dieser Schalteinheiten (28) einen Setzspeicher (50) aufweist, der eine initiierte Sperrung dauerhaft aufrechterhält.

6. Leistungsverteiler (2) nach einem der Ansprüche 1 bis 5,
**dadurch gekennzeichnet,**
**dass** eine Art "Lock"-Funktion realisiert ist, mittels derer die Reaktionsfähigkeit der anderen Schalteinheit (28) oder aller übrigen Schalteinheiten (28) zeitweise, insbesondere für eine Zeitdauer von etwa 100 bis etwa 300 µs, blockiert wird, sobald eine Schalteinheit (28) aufgrund eines Fehlerfalls reagiert hat.

7. Leistungsverteiler (2) nach einem der Ansprüche 1 bis 6,
**dadurch gekennzeichnet,**
**dass** die beiden Schalteinheiten (28) räumlich voneinander getrennt sowie insbesondere in separaten Gehäusen (66) angeordnet sind und dass der Zwischenabgriff (16) als Leiterverbindung ausgebildet ist, die die beiden Schalteinheiten (28) bzw. die beiden Gehäuse (66) elektrisch leitend miteinander verbindet.

8. Bordnetz (4) für ein Kraftfahrzeug (6) mit zumindest einem Leistungsverteiler (2) gemäß einem der vorherigen Ansprüche.

9. Bordnetz (4) nach Anspruch 8,
**dadurch gekennzeichnet,**
**dass** dieses mehrere Leistungsverteiler (2) gemäß einem der vorherigen Ansprüche aufweist, wobei an jeden Leistungsverteiler (2) über dessen Zwischenabgriff (16) eine Anzahl elektrischer Verbraucher (18) angeschlossen ist, wobei die Leistungsverteiler (2) über ihre Leistungsausgänge (10) und dazwischenliegende Verbindungsleiter (12) untereinander verbunden sind und wobei an zwei Leistungsausgängen (10) oder an zwei Zwischenabgriffen (16) oder an einem Leistungsausgang (10) und an einem Zwischenabgriff (16) zweier Leistungsverteiler (2) zwei elektrische Energiequellen (14) für eine redundante Versorgung der elektrischen Verbraucher (18) mit elektrischer Leistung angeschlossen sind, so dass bei einem Kurzschluss entlang einem der Verbindungsleiter (12) dieser durch die angeschlossenen Leistungsverteiler (2) elektrisch isoliert wird.

10. Bordnetz (4) nach Anspruch 9,
**dadurch gekennzeichnet,**
**dass** die Leistungsverteiler (2) eine Verteilerkette ausbilden, an deren Enden je eine der elektrischen Energiequellen (14) über einen Versorgungsausgang (16) oder einen Leistungsausgang (10) angeschlossen ist.

11. Bordnetz (4) nach Anspruch 9,
**dadurch gekennzeichnet,**
**dass** die Leistungsverteiler (2) einen Verteilerring ausbilden, wobei an zwei Leistungsverteilern (2) jeweils eine elektrische Energiequelle (14) über einen Versorgungsausgang (16) oder einen Leistungsausgang (10) angeschlossen ist.

12. Bordnetz (4) nach Anspruch 8,
**gekennzeichnet durch** eine Anzahl sicherheitsrelevanter elektrischer Verbraucher (62), die zur Realisierung einer sicherheitsrelevanten Funktion genutzt werden, und eine Anzahl sonstiger elektrischer Verbraucher (64) sowie ein erstes Teilbordnetz (58) und ein zweites Teilbordnetz (60), wobei das erste und das zweite Teilbordnetz (58,60) über den Leistungsverteiler (2) miteinander verbunden sind, wobei die sicherheitsrelevanten elektrischen Verbraucher (64) zur redundanten Versorgung jeweils in beide Teilbordnetze (58,60) eingebunden sind und wobei die sonstigen elektrischen Verbraucher (64) zur einfachen Versorgung jeweils in eines der beide Teilbordnetze (58,60) eingebunden sind.

13. Bordnetz (4) nach Anspruch 12,
**dadurch gekennzeichnet,**
**dass** alle sonstigen elektrischen Verbraucher (64) in das erste Teilbordnetz (58) eingebunden sind.

14. Bordnetz (4) nach Anspruch 8,
**gekennzeichnet durch**
eine Anzahl sicherheitsrelevanter elektrischer Verbraucher (62), die zur Realisierung einer sicherheitsrelevanten Funktion genutzt werden, und eine Anzahl sonstiger elektrischer Verbraucher (64) sowie ein erstes Teilbordnetz (58) und ein zweites Teilbordnetz (60), wobei das erste und das zweite Teilbordnetz (58,60) über den Leistungsverteiler (2) miteinander verbunden sind, wobei die sicherheitsrelevanten elektrischen Verbraucher (64) zur redundanten Versorgung jeweils in beide Teilbordnetze (58,60) eingebunden sind und wobei die sonstigen elektrischen Verbraucher (64) zur einfachen Versorgung an den Zwischenabgriff (16) angebunden sind.

15. Bordnetz (4) nach Anspruch 14,
**dadurch gekennzeichnet,**
**dass** die sonstigen elektrischen Verbraucher (64) über eine zusätzliche Schalteinheit (28) oder über einen zusätzlichen Leistungsverteiler (2) gemäß einem der vorherigen Ansprüche an den Zwischenabgriff (16) angebunden sind.

## Claims

1. Power distributor (2), in particular for an on-board network (4) of a motor vehicle (6), comprising two power outputs (10), an intermediate tap (16) and a respective switching unit (28) for each power output (10) with a switch (30) for blocking the associated power output (10) as required, wherein
- each of these switching units (28) is designed in such a way that the associated power output (10) is blocked if in the event of a voltage drop below a first setpoint value at the associated power output (10) and/or at the intermediate tap (16) a fault situation is detected, wherein the blocking of the associated power output (10) takes place the faster the higher the corresponding voltage drop is,
- each of said switching units (28) is linked to a voltage monitoring unit (44), by means of which the voltages at the power outputs (10) and/or the voltage at the intermediate tap (16) are monitored, or wherein each of these switching units (28) comprises a voltage monitoring unit (44), by means of which the voltage at the associated power output (10) and/or at the intermediate tap (16) is monitored and
- a delay element (56) is connected upstream of each voltage monitoring unit (44), so that a voltage drop at the associated power output (10) and/or at the intermediate tap (16) causes a voltage drop with a modified time characteristic at the respective voltage monitoring unit (44).

2. Power distributor (2) according to claim 1,
**characterized in**
**that** it is designed in such way that in the event of a fault situation, the power output respectively connected most directly to the fault source and, in particular, respectively only the power output connected most directly to the fault source is blocked.

3. Power distributor (2) according to claim 1 or 2,
**characterized in**
**that** the intermediate tap (16) is designed as a distribution node or as a supply output (16) for supplying a number of electrical consumers (18).

4. Power distributor (2) according to one of claims 1 to 3,
**characterized in**
**that** each voltage monitoring unit (44) comprises a comparator circuit (44), by means of which the voltage at the associated power output (10) and/or at the intermediate tap (16) is compared to a generated reference voltage, wherein the reference voltage (U_{Ref}) corresponds to the first setpoint value.

5. Power distributor (2) according to one of claims 1 to 4,
**characterized in**
**that** each of said switching units (28) comprises a set memory (50) which permanently maintains an initiated blocking.

6. Power distributor (2) according to one of claims 1 to 5,
**characterized in**
**that** a type of "lock" function is implemented, by means of which the responsiveness of the other switching unit (28) or of all other switching units (28) is temporarily blocked, in particular for a period of about 100 to about 300 µs, as soon as one switching unit (28) has responded due to a fault situation.

7. Power distributor (2) according to one of claims 1 to 6,
**characterized in**
**that** the two switching units (28) are spatially separated from one another and, in particular, are arranged in separate housings (66), and in that the intermediate tap (16) is designed as a conductor connection connecting the two switching units (28), respectively the two housings (66) to one another in an electrically conductive manner.

8. On-board network (4) for a motor vehicle (6) with at least one power distributor (2) according to one of the preceding claims.

9. On-board network (4) according to claim 8,
**characterized in**
**that** it comprises a plurality of power distributors (2) according to one of the preceding claims, wherein a number of electrical consumers (18) are connected to each power distributor (2) via its intermediate tap (16), wherein the power distributors (2) are connected to one another via their power outputs (10) and intermediate connecting conductors (12) and wherein two electrical energy sources (14) for a redundant supply of electrical power to the electrical consumers (18) are connected to two power outputs (10) or to two intermediate taps (16) or to one power output (10) and to one intermediate tap (16) of two power distributors (2), so that in the event of a short circuit along one of the connecting conductors (12), said conductor is electrically insulated by the connected power distributors (2).

10. On-board network (4) according to claim 9,
**characterized in**
**that** the power distributors (2) form a distribution chain, to the ends of which in respectively one of the electrical energy sources (14) is connected via a supply output (16) or a power output (10).

11. On-board network (4) according to claim 9,
**characterized in**
**that** the power distributors (2) form a distributor ring, with an electrical energy source (14) being respectively connected to two power distributors (2) via a supply output (16) or a power output (10).

12. On-board network (4) according to claim 8,
**characterised by**
a number of safety-relevant electrical consumers (62), which are used to implement a safety-relevant function, and a number of other electrical consumers (64) as well as a first partial on-board system (58) and a second partial on-board system (60), wherein the first and second partial on-board systems (58,60) are connected to one another via the power distributor (2), and wherein the safety-relevant electrical consumers (64) each are integrated into both partial on-board systems (58,60) for redundant supply and with the other electrical consumers (64) each are integrated into one of the two partial on-board systems (58,60) for simple supply.

13. On-board network (4) according to claim 12,
**characterized in**
**that** all other electrical consumers (64) are integrated into the first partial on-board system (58).

14. On-board network (4) according to claim 8,
**characterised by**
a number of safety-relevant electrical consumers (62), which are used to implement a safety-relevant function, and a number of other electrical consumers (64) as well as a first partial on-board system (58) and a second on-board electrical system (60), wherein the first and second partial on-board systems (58,60) are connected to one another via the power distributor (2), with the safety-relevant electrical consumers (64) each being integrated into both partial on-board systems (58,60) for redundant supply and with the other electrical consumers (64) being connected to the intermediate tap (16) for simple supply.

15. On-board network (4) according to claim 14,
**characterized in**
**that** the other electrical consumers (64) are connected to the intermediate tap (16) via an additional switching unit (28) or via an additional power distributor (2) according to one of the preceding claims.

## Revendications

1. Distributeur de puissance (2), en particulier pour un réseau de bord (4) d'un véhicule automobile (6), comportant deux sorties de puissance (10), une prise intermédiaire (16) et une unité de commutation (28) pour chaque sortie de puissance (10) avec un commutateur (30) pour bloquer la sortie de puissance (10) associée en cas de besoin, dans lequel
- chacune desdites unités de commutation (28) est conçue de telle manière que la sortie de puissance (10) correspondante est bloquée en cas de chute de tension inférieure à une première valeur de consigne à la sortie de puissance (10) correspondante et/ou à la prise intermédiaire (16) si une condition de défaut est constatée, dans lequel le blocage de la sortie de puissance (10) correspondante est d'autant plus rapide que la chute de tension correspondante est importante,
- chacune desdites unités de commutation (28) est reliée à une unité de surveillance de la tension (44), au moyen de laquelle les tensions aux sorties de puissance (10) et/ou la tension à la prise intermédiaire (16) sont surveillées, ou dans lequel chacune desdites unités de commutation (28) comporte une unité de surveillance de la tension (44), au moyen de laquelle la tension à la sortie de puissance associée (10) et/ou à la prise intermédiaire (16) est surveillée et
- un temporisateur (56) est connecté en amont de chaque unité de surveillance de la tension (44), de sorte qu'une chute de tension à la sortie de puissance associée (10) et/ou à la prise intermédiaire (16) provoque une chute de tension avec une caractéristique temporelle modifiée à l'unité de surveillance de la tension (44) respective.

2. Distributeur de puissance (2) selon la revendication 1,
**caractérisé en ce**
**qu'**il est conçu de telle manière qu'en cas de défaut, la sortie de puissance connectée le plus directement à la source de défaut dans chaque cas et, en particulier, seule la sortie de puissance connectée le plus directement à la source de défaut dans chaque cas est bloquée.

3. Distributeur de puissance (2) selon la revendication 1 ou 2,
**caractérisé en ce**
**que** la prise intermédiaire (16) est conçue comme un nœud de distribution ou comme une sortie d'alimentation (16) pour l'alimentation d'un certain nombre de consommateurs électriques (18).

4. Distributeur de puissance (2) selon l'une des revendications 1 à 3,
**caractérisé en ce**
**que** chaque unité de surveillance de la tension (44) comporte un circuit comparateur (44) au moyen duquel la tension à la sortie de puissance associée (10) et/ou à la prise intermédiaire (16) est comparée à une tension de référence générée, dans lequel la tension de référence (U_{Ref}) corresponde à la première valeur de consigne.

5. Distributeur de puissance (2) selon l'une des revendications 1 à 4,
**caractérisé en ce**
**que** chacune desdites unités de commutation (28) dispose d'une mémoire de réglage (50) qui maintient en permanence un blocage initié.

6. Distributeur de puissance (2) selon l'une des revendications 1 à 5,
**caractérisé en ce**
**qu'**un type de fonction de "verrouillage" est réalisé, au moyen de laquelle la réactivité de l'autre unité de commutation (28) ou de toutes les autres unités de commutation (28) est temporairement bloquée, en particulier pendant une période d'environ 100 à environ 300 µs, dès qu'une unité de commutation (28) a répondu en raison d'un cas de défaut.

7. Distributeur de puissance (2) selon l'une des revendications 1 à 6,
**caractérisé en ce**
**que** les deux unités de commutation (28) sont spatialement séparées l'une de l'autre et sont en particulier disposées dans des boîtiers (66) séparés, et **en ce que** la prise intermédiaire (16) est conçue comme une connexion de conducteur qui rélie les deux unités de commutation (28), respectivement les deux boîtiers (66) de manière électriquement conductrice.

8. Réseau de bord (4) d'un véhicule automobile (6) avec au moins un distributeur de puissance (2) selon l'une des revendications précédentes.

9. Réseau de bord (4) selon la revendication 8,
**caractérisé en ce**
**qu'**il comprend une pluralité de distributeurs de puissance (2) selon l'une des revendications précédentes, dans lequel un certain nombre de consommateurs électriques (18) est connecté à chaque distributeur de puissance (2) via sa prise intermédiaire (16), dans lequel les distributeurs de puissance (2) sont reliés entre eux par leurs sorties de puissance (10) et leurs conducteurs de connexion (12) intermédiaires et dans lequel à deux sorties de puissance (10) ou à deux prises intermédiaires (16) ou à une sortie de puissance (10) et à une prise intermédiaire (16) de deux distributeurs de puissance (2), deux sources d'énergie électrique (14) pour une alimentation redondante en puissance électrique des consommateurs électriques (18) sont reliées, de sorte qu'en cas de court-circuit le long d'un des conducteurs de connexion (12), ce dernier est isolé électriquement par les distributeurs de puissance (2) raccordés.

10. Réseau de bord (4) selon la revendication 9,
**caractérisé en ce**
**que** les distributeurs de puissance (2) forment une chaîne de distribution, aux extrémités de laquelle, dans chaque cas, une des sources d'énergie électrique (14) est reliée par une sortie d'alimentation (16) ou une sortie de puissance (10).

11. Réseau de bord (4) selon la revendication 9,
**caractérisé en ce**
**que** les distributeurs de puissance (2) forment un anneau de distribution, dans lequel à deux distributeurs de puissance (2) respectivement une source de puissance électrique (14) est reliée par une sortie d'alimentation (16) ou une sortie de puissance (10).

12. Réseau de bord (4) selon la revendication 8,
**caractérisé par**
un certain nombre de consommateurs électriques d'importance sécuritaire (62) qui sont utilisées pour réaliser une fonction d'importance sécuritaire, et un certain nombre d'autres consommateurs électriques (64) ainsi qu'un premier réseau de bord partiel (58) et un deuxième réseau de bord partiel (60), dans lequel le premier et le deuxième réseau de bord partiel (58, 60) sont reliés par le distributeur de puissance (2), dans lequel les consommateurs électriques (64) d'importance sécuritaire sont intégrés chacun dans les deux réseaux de bord partiels (58, 60) pour une alimentation redondante et les autres consommateurs électriques (64) sont intégrés chacun dans l'un des deux réseaux de bord partiels (58, 60) pour une alimentation facile.

13. Réseau de bord (4) selon la revendication 12,
**caractérisé en ce**
**que** tous les autres consommateurs électriques (64) sont intégrés dans le premier réseau de bord partiel (58).

14. Réseau de bord (4) selon la revendication 8,
**caractérisé par**
un certain nombre de consommateurs électriques d'importance sécuritaire (62) qui sont utilisées pour réaliser une fonction d'importance sécuritaire, et un certain nombre d'autres consommateurs électriques (64) ainsi qu'un premier réseau de bord partiel (58) et un deuxième réseau de bord partiel (60), dans lequel le premier et le deuxième réseau de bord (58, 60) sont reliés entre eux par le distributeur de puissance (2), dans lequel les consommateurs électriques (64) d'importance sécuritaire sont intégrés dans les deux réseaux de bord partiels (58, 60) pour une alimentation redondante et les autres consommateurs électriques (64) sont reliés à la prise intermédiaire (16) pour une alimentation facile.

15. Réseau de bord (4) selon la revendication 14,
**caractérisé en ce**
**que** les autres consommateurs électriques (64) sont raccordés à la prise intermédiaire (16) par l'intermédiaire d'une unité de commutation supplémentaire (28) ou d'un distributeur de puissance (2) supplémentaire selon l'une des revendications précédentes.
